# EUROPÄISCHE PATENTSCHRIFT

(11) **EP 0 545 863 B1**
(45) Veröffentlichungstag und Bekanntmachung des Hinweises auf die Patenterteilung: **19.03.1997**
(21) Anmeldenummer: 92810910.7
(22) Anmeldetag: 23.11.1992
(51) Int. Cl.: C23C 14/32, C23C 14/20, B65D 65/40

(54) **Beschichten einer Substratfläche mit einer Permeationssperre**
Coating a substrate surface with a permeation barrier
Dépôt d'une barrière imperméable sur la surface d'un substrat

(30) Priorität: 05.12.1991 CH 3574/91
(43) Veröffentlichungstag der Anmeldung: 09.06.1993
(73) Patentinhaber: Alusuisse Technology & Management AG, 8212 Neuhausen am Rheinfall (CH)
(72) Erfinder: Lohwasser, Wolfgang, CH-8200 Schaffhausen (CH)

(56) Entgegenhaltungen:
- EP-A- 0 240 571
- EP-A- 0 444 538
- DE-A- 3 543 316
- PATENT ABSTRACTS OF JAPAN vol. 3, no. 23 (C-38)26. Februar 1979 & JP-A-53149876
- PATENT ABSTRACTS OF JAPAN vol. 5, no. 137 (E-72)(809) 29. August 1981 & JP-A-56071927
- PATENT ABSTRACTS OF JAPAN vol. 12, no. 491 (C-554)(3338) 21. Dezember 1988 & JP-A-60203767
- JOURNAL OF VACUUM SCIENCE AND TECHNOLOGY, A Bd. 6, Nr. 1, Januar 1988, WOODBURY, NY, US Seiten 134 - 138 H. ERICH 'THE ANODIC VACUUM ARC. 1. BASIC CONSTRUCTION AND PHENOMENOLOGY'

## Beschreibung

Die Erfindung bezieht sich auf ein Verfahren zum Beschichten einer Substratfläche mit einer Permeationssperre aus anorganischem Material, welches in einer auf wenigstens 10⁻³ mbar evakuierten Vakuumkammer aus einem Tiegel verdampft und auf der Substratfläche niedergeschlagen wird. Weiter betrifft die Erfindung ein Beschichtungswerkzeug zur Durchführung und eine Anwendung des Verfahrens.

Das thermische Aufdampfen ist das am häufigsten gebrauchte Verfahren für die Herstellung von optischen Beschichtungen. Anhand dieser Schichten ist erkannt worden, dass wesentliche mechanische Eigenschaften von Schichten denjenigen von entsprechenden Festkörpern unterlegen sind. Weiter ist erkannt worden, dass Abscheidungsprozesse mit Partikeln höherer kinetischer Energie als bei einer normalen thermischen Abscheidung zu verbesserten mechanischen Eigenschaften führen. Die ionenunterstützte Abscheidung (IAD = Ion Assisted Deposition) ist einer dieser Abscheidungsprozesse.

Die DE-C2 3543316 beschreibt ein Verfahren zum reaktiven Aufdampfen von elektrisch isolierenden Schichten auf Unterlagen, unter gleichzeitiger teilweiser Ionisation des Dampfes mittels einer Niedervoltbogenentladung und Beschleunigung der erzeugten Ionen auf die zu beschichtende Oberfläche. Zwischen einer Dampfquelle als Anode und den gegenüber der Anode auf negativem Potential befindlichen Substratflächen wird ein elektrisches Feld aufrecht erhalten. Während der Beschichtung wird mittels einer elektrischen Gasentladung vor der zu beschichtenden Fläche ein elektrisches Plasma erzeugt. Die elektrische Gasentladung wird so eingestellt, dass sich die Substratoberflächen gegenüber dem Plasmapotential auf ein Potential von -5 bis -60 Volt aufladen. Die Ioneneinfallsdichte beträgt 0,5 - 3 mA/cm². Die zum reaktiven Aufdampfen erforderlichen, mit der verdampften Substanz zur Reaktion zu bringenden Gase werden am Ort der höchsten Dampfdichte vor der Anode zugeführt.

Aus der US-A 3442686 ist eine transparente Verpackungsfolie mit niedriger Permeabilität für Gase und Flüssigkeiten bekannt. Die 0,02 bis 2 µm dicke Gas- und Flüssigkeitsbarriere besteht aus einem auf eine Kunststoffolie aufgedampften anorganischen Material glasartiger Natur. Auf diese Sperrschicht wird eine weitere Kunststoffolie aufgebracht. Als Hauptfunktionen der Verpackungsfolie werden der mechanische Schutz des Inhalts, der Schutz gegen Verschmutzung und Feuchtigkeit, die Verhütung von Verlusten an Verpackungsinhalt und die vorteilhafte Erscheinungsform erwähnt.

Es sind mehrere Bandbeschichtungsanlagen für Kunststoffolien mit einem Elektronenstrahlverdampfer bekannt, beispielsweise von den Firmen Leibold, BVT oder Galileo. Die nach bekannten Aufdampf-Verfahren hergestellten Schichten sind nicht hinreichend kompakt, die Dichte des Materials beträgt z.B. bei Siliziumdioxid nur 80 % der Dichte eines Festkörpers aus dem gleichen Material.

Eine nicht kompakte Schicht weist eine geringe Stabilität und eine ungenügende Haftung am Substrat auf. Um bei reaktiver Bedampfung stöchiometrische Schichten zu erhalten, muss mit hohem Reaktivgaspartialdruck gearbeitet werden, wodurch noch weniger dichte Schichten entstehen.

Weiter können bisher bekannte Verfahren der Nachionisation nur bei kleinen Verdampferquellen und niedrigen Beschichtungsraten angewandt werden, da sie entweder nicht skalierbar sind oder zu geringe Ionisationsraten aufweisen.

Die Erfinder haben sich die Aufgabe gestellt, ein Verfahren der eingangs genannten Art und ein Beschichtungswerkzeug zur Durchführung des Verfahrens zu schaffen, welche gegenüber bekannten IAD-Prozessen eine wesentlich grössere nutzbare Substratfläche erlauben, und auch bei hohen Relativgeschwindigkeiten zur Verdampfungsquelle kompakte Schichten mit besserer Barrierewirkung (Permeationssperre) erlauben.

In bezug auf das Verfahren wird die Aufgabe erfindungsgemäss nach dem Kennzeichen von Patentanspruch 1 gelöst. Bevorzugte und weiterbildende Ausführungsformen sind Gegenstand von abhängigen Patentansprüchen.

Das anorganische Material zur Bildung der gegen Gase und Flüssigkeiten, eingeschlossen Aromastoffe, wirksamen Barriere kann auf beliebige Art verdampft werden. Wesentlich ist das Durchschiessen des Materialdampfs mit einem ionisierenden Elektronenstrahl niedriger Energie zur Erzeugung eines Plasmas. Obwohl sich dieser Elektronenstrahl von seiner Quelle aus kegelförmig ausbreitet, wird vereinfachend davon gesprochen, dass er etwa parallel zur Substratoberfläche verlaufe. Diese Aussage ist im Prinzip nur für den axialen Strahl des Kegels richtig, weil nur dieser wirklich parallel zur Substratfläche oder zu deren dem Tiegel zugewandten Tangentialfläche verläuft. Der wesentliche Aspekt der vereinfachenden Aussage besteht jedoch darin, dass der ionisierende Elektronenstrahl nicht vom Tiegel zum Substrat oder umgekehrt verläuft.

Der ionisierende Elektronenstrahl wird vorzugsweise mit einer Spannung von 10 bis 100 Volt und einer Stromstärke von 0 bis 300 A erzeugt und aufrecht erhalten, wobei zweckmässig eine an sich bekannte Niederspannungs-Elektronenstrahlkanone, z.B. eine Hohlkathoden-Elektronenquelle (HKE) verwendet wird. Zweckmässig wird in an sich bekannter Weise ein Edelgas, insbesondere Argon, und/oder Stickstoff zudosiert.

Der ionisierende Elektronenstrahl wird vorzugsweise im mittleren Drittel zwischen dem Tiegel und der Substratfläche durch die Gasphase aus anorganischem Material geleitet, insbesondere etwa in der Mitte.

Als verdampfbare anorganische Materialien sind alle an sich bekannten Werkstoffe geeignet, die nach dem Abscheiden aus der Gasphase, ohne oder mit einer chemischen Reaktion, eine Schicht bilden, welche eine Gas- und Feuchtigkeitsbarriere bilden. Als Beispiele seien Siliziummonoxid, Siliziumdioxid, Titanoxid, Zirkonoxid, Aluminiumoxid, Magnesiumoxid erwähnt. Diese Oxide können auch gemischt oder dotiert sein. Weiter können die Metalle verdampft werden und während des Beschichtungsverfahrens wenigstens ein reaktives Gas, beispielsweise Sauerstoff, Stickstoff, Wasserstoff und/oder Acetylen, zugeführt werden. Dabei können die entsprechenden Oxide, Nitride, Karbide oder Mischkomponenten entstehen. Selbstverständlich können auch reaktive Gase zugeführt werden, wenn das zu verdampfende Material bereits als Oxid, Nitrid und/oder Karbid vorliegt.

Vor der Zudosierung wenigstens eines reaktiven Gases, dessen Aktivität durch das Plasma erhöht wird, wird die Vakuumkammer auf unter 10⁻⁴ mbar evakuiert und dann die entsprechende Menge Gas zudosiert.

Bevorzugt wird das im Tiegel befindliche anorganische Material durch Beaufschlagung mit einem Elektronenstrahl aus einer scannenden Hochspannungs-Elektronenstrahlkanone verdampft. Unter "scannend" wird hier nach fachmännischer Usanz verstanden, dass der Elektronenstrahl die Oberfläche des zu verdampfenden anorganischen Materials programmgesteuert abfährt. Die an die Hochspannungs-Elektronenstrahlkanone angelegte Spannung liegt bevorzugt bei wenigstens 5 kV, insbesondere bei wenigstens 10 kV, bei einer Stromstärke von weniger als 2 A. Die Hochspannungs-Elektronenstrahlkanone arbeitet beispielsweise mit einer Energie von 35 keV, was gegenüber der das Plasma erzeugenden Niederspannungs-Elektronenstrahlkanone mit einer Elektronenenergie von beispielsweise 50 - 100 eV ein sehr hoher Wert ist.

Durch eine sich am Substrat gegenüber dem Plasma einstellende negative "Selfbias"-Spannung werden die ionisierten positiven Materialteilchen gegen das Substrat beschleunigt, was zu einem besseren Schichtwachstum beiträgt. An ein elektrisch leitendes Substrat kann auch ein negatives Potential angelegt werden.

Falls die Wand der Vakuumkammer gegenüber der Anode isoliert ist, kann mit einer zusätzlichen Spannungsquelle das Potential der Anode angehoben werden, vorzugsweise von 20 - 100 V, was zu einer höheren Potentialdifferenz zwischen Plasma und Substrat führt, was wiederum zu einer höheren Beschleunigung der ionisierten Materialteilchen führt.

Durch Dauermagnete mit Joch oder entsprechend dimensionierten Gleichstromspulen kann ein zusätzliches, auch einstellbares Magnetfeld erzeugt werden. Nach einer ersten Variante verläuft das Magnetfeld in Folienlaufrichtung parallel zum Plasmastrahl. Feldstärke des zusätzlichen Magnetfeldes, welches ein besseres, intensiveres Plasma erzeugt, beträgt minimal 10 Gauss. vom Tiegel zurückgestreuten Elektronen werden vom Magnetfeld abgelenkt und am Erreichen der Substratfolie verhindert. Das zusätzliche Magnetfeld wird so abgeschirmt, dass der Elektronenstrahl der Hochspannungs-Elektronenstrahlkanone nicht beeinflusst wird. Nach einer zweiten Variante kann dieser so angeordnet sein, dass der Elektronenstrahl überall einen um 90° verschiedenen Winkel mit der Tiegelachse bildet, also wie parallel zum Magnetfeld verläuft. Durch entsprechende Wahl der Polarität des Elektronenstrahles kann erreicht werden, dass die Elektronen in Richtung des Tiegels abgelenkt werden, wie dies an sich aus der DE, C1 4113364 bekannt ist.

Die Anode kann durch den Tiegel oder durch eine andere geeignete Fläche gebildet sein, z.B. ein Rohr, Blech, Profil, Gitter oder Draht.

Mit dem erfindungsgemässen Verfahren werden auf dem Substrat Niederschlagsraten erzielt, die wenigstens bei 0,01 µm/sec liegen, vorzugsweise jedoch im Bereich von 0,5 - 1 µm/sec. Diese Abscheidungsraten sind verglichen mit denjenigen beim optischen Aufdampfen sehr hoch.

Vorzugsweise werden mit dem erfindungsgemässen Verfahren beschichtete Substratflächen, insbesondere Kunststoffolien, bewegt. Die Geschwindigkeit von durchlaufenden Kunststoffolien liegt zweckmässig im Bereich von 1 bis 10 m/sec, insbesondere bei 3 - 6 m/sec. Die Kunststoffolien bestehen beispielsweise aus Polyester (PET), Polyäthylen (PE), Polypropylen (PP) oder Polyamid (PA).

In bezug auf das Beschichtungswerkzeug zur Durchführung des Verfahrens wird die Aufgabe erfindungsgemäss dadurch gelöst, dass zwischen dem Tiegel und dem Substrat wenigstens eine Niederspannungs-Elektronenstrahlkanone, welche einen Elektronenstrahl aussendet/aussenden, mit zugeordneter Anode in die Vakuumkammer eingebaut ist.

An sich bekannte Niederspannungs-Elektronenstrahlkanonen sind vorzugsweise als Hohlkathoden-Elektronenquellen ausgebildet. Bei einer Folienbreite von beispielsweise 2,5 m können sieben Hohlkathoden-Elektronenquellen nebeneinander angeordnet sein, wobei sich deren Wirkungsbereiche zweckmässig überlappen. Die Anoden der Hohlkathoden-Elektronenquellen können separat oder gemeinsam ausgebildet sein. Das erzeugte Plasma erstreckt sich mit homogenem Potential über die ganze Folienbreite.

Der Tiegel mit dem zu verdampfenden anorganischen Material ist vorzugsweise entsprechend, sich bei breiten Substratflächen linear erstreckend, ausgebildet. Eine Tiegelwand kann entsprechend verlängert sein und die Anode der Niederspannungs-Elektronenstrahlkanone/n bilden. In diesem Fall ist der Tiegel zweckmässig von der Wand der Vakuumkammer isoliert.

Eine erfindungsgemässe Anwendung des Verfahrens dient der Beschichtung von Kunststoffolien für die Verpackungsindustrie. Hier wirken sich die Vorteile besonders günstig aus:
- Kompaktere, sehr gut haftende Schichten auf dem Substrat, dadurch bessere Barrierewirkung gegen Gase und Flüssigkeiten, insbesondere Sauerstoff, Wasser und Aromen,
- geringe Wasseraufnahme der Schichten,
- langzeitige Stabilität der Schichten.

Das erfindungsgemässe Verfahren mit einer Ionenunterstützung während des Aufdampfens bringt eine deutliche Verbesserung des Permeationswertes der Siliciumoxidschichten. Die Zugabe von Stickstoff zur Niederspannungs-Elektronenstrahlkanone führt zu anderen Resultaten als die Zugabe des Edelgases Argon. Je nach dem Aufdampfen von Siliciummonoxid oder Siliciumdioxid erweist sich die Zugabe von Stickstoff oder Argon als besser. Der Grund dürfte darin liegen, dass bei einem SiO-System Stickstoff auch als reaktives Gas wirkt. Das als Barriere wirkende Schichtmaterial wird dabei mit Stickstoffatomen dotiert.

Die Erfindung wird anhand von in der Zeichnung dargestellten Ausführungsbeispielen, welche auch Gegenstand von abhängigen Ansprüchen, näher erläutert. Es zeigen:
- - Fig. 1: eine Prinzipskizze eines Beschichtungswerkzeugs, zeugs,
- - Fig. 2: einen Teilschnitt durch eine hergestellte Verbundfolie,
- - Fig. 3: die elektrische Infrastruktur eines Beschichtungswerkzeugs gemäss Fig. 1,
- - Fig. 4: eine Variante von Fig. 3,
- - Fig. 5: eine Anode der Niederspannungs-Elektronenstrahlkanone aus einem Draht mit gekühlter Halterung,
- - Fig. 6: eine Anode gemäss Fig. 5 aus einem Gitter, und
- - Fig. 7: eine rohrförmige Anode entsprechend Fig. 5.

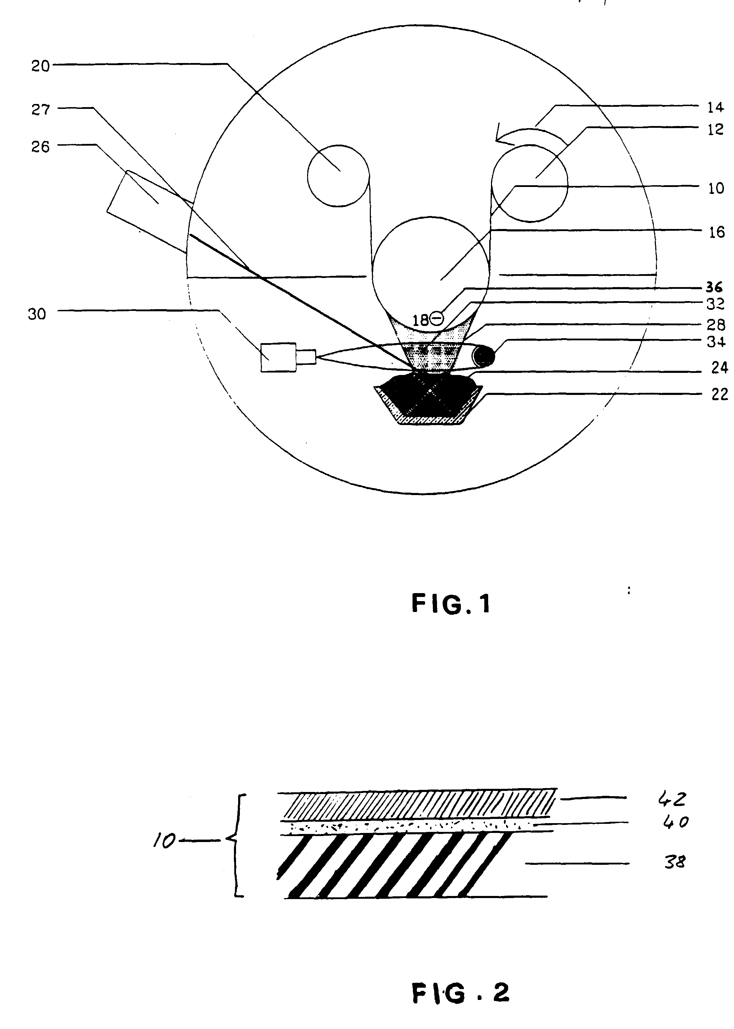

Nach der Ausführungsform von Fig. 1 wird eine Kunststoffolie 10 von einer Rolle 12 in Richtung des Pfeils 14 abgewickelt und über eine Walze 16 gezogen. Die auf der Walze 16 als Substratträger aufliegende Kunststoffolie 10 bildet im Arbeitsbereich die Substratfläche 18. Nach der Beschichtung wird die Kunststoffolie 10 auf eine weitere Rolle 20 aufgewickelt. Allfällige Umlenkrollen sind einfachheitshalber nicht gezeichnet.

In einem Tiegel 22 befindet sich das zu verdampfende anorganische Material 24, welches von einer scannenden Hochspannungs-Elektronenstrahlkanone 26 erhitzt und in geringem Umfang ionisiert wird. Durch die Energie des Elektronenstrahls 27 bildet sich eine Gasphase 28 aus anorganischem Material 24.

Eine als Hohlkathoden-Elektronenquelle ausgebildete Niederspannungs-Elektronenstrahlkanone 30 erzeugt einen die Gasphase 28 aus anorganischem Material 24 durchdringenden Elektronenstrahl 32. Die Elektronen treffen auf der Anode 34 der Niederspannungs-Elektronenstrahlkanone 30 auf. Dieser ionisierende Elektronenstrahl 32 verläuft etwa horizontal.

Auf der Substratfläche 18 bildet sich eine"Selfbias"-Spannung aus, welche zu einem negativen Potential führt, was mit einem Minuszeichen 36 angedeutet ist.

Die in Fig. 2 dargestellte Verbundfolie 10 umfasst eine organische Basisfolie 38, eine ionenunterstützt aufgedampfte, 0,01 - 2 µm dicke anorganische Schicht 40 und eine siegelbare organische Folie 42, welche nach dem Bedampfen aufgebracht worden ist.

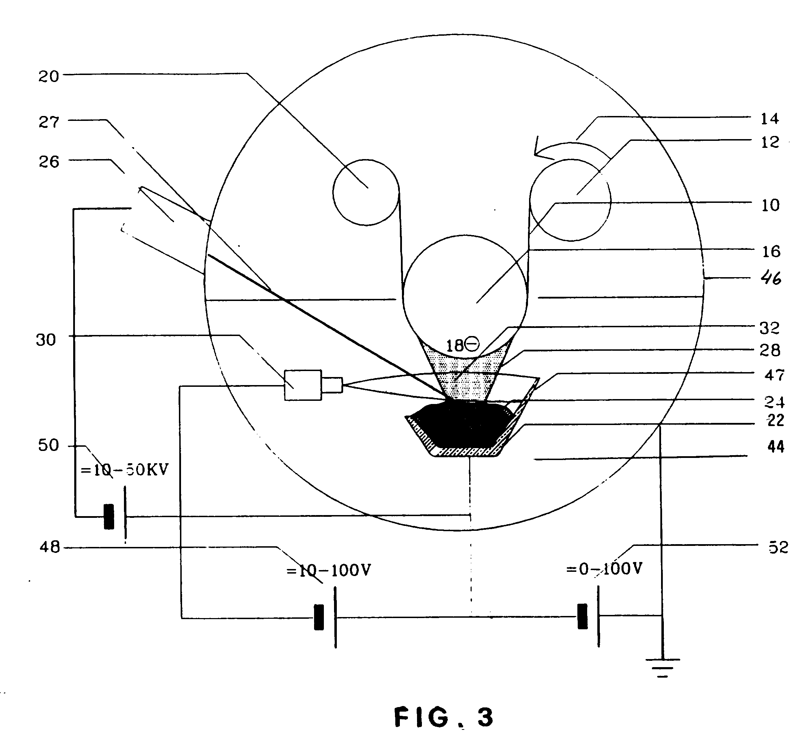

In Fig. 3 ist eine Vakuumkammer 44 mit einer Wand 46 dargestellt, welche eine Hochspannungs-Elektronenstrahlkanone 26, eine Niederspannungs-Elektronenstrahlkanone 30 mit angedeutetem Elektronenstrahl 32 und den Tiegel 22 mit dem verdampfbaren anorganischen Material 24 umfasst. Die von der Niederspannungs-Elektronenstrahlkanone 30 abgewandte Tiegelwand 47 ist verlängert ausgebildet und dient als Anode für den Elektronenstrahl 32.

Eine erste Stromquelle 48, welche elektrisch mit dem Tiegel 22 verbunden ist und die Niederspannungs-Elektronenstrahlkanone 30 speist, kann bei einer Spannung bis 100 V einen Strom bis 300 A abgeben.

Eine zweite, ebenfalls elektrisch mit dem Tiegel 22 verbundene Stromquelle 50 für die Speisung der Hochspannungs-Elektronenstrahlkanone 26 gibt bei einer Spannung von 50 kV einen Strom von höchstens 2 A ab.

Eine dritte Stromquelle 52 ist variabel in einem Bereich 0 - 100 V einstellbar. Diese Stromquelle 52 ist wie die übrigen mit dem Tiegel 22 elektrisch verbunden. Die andere, geerdete Leitung ist mit der Wand 46 der Vakuumkammer 44 elektrisch verbunden, welche folglich ein anderes Potential als der Tiegel 22 annehmen kann.

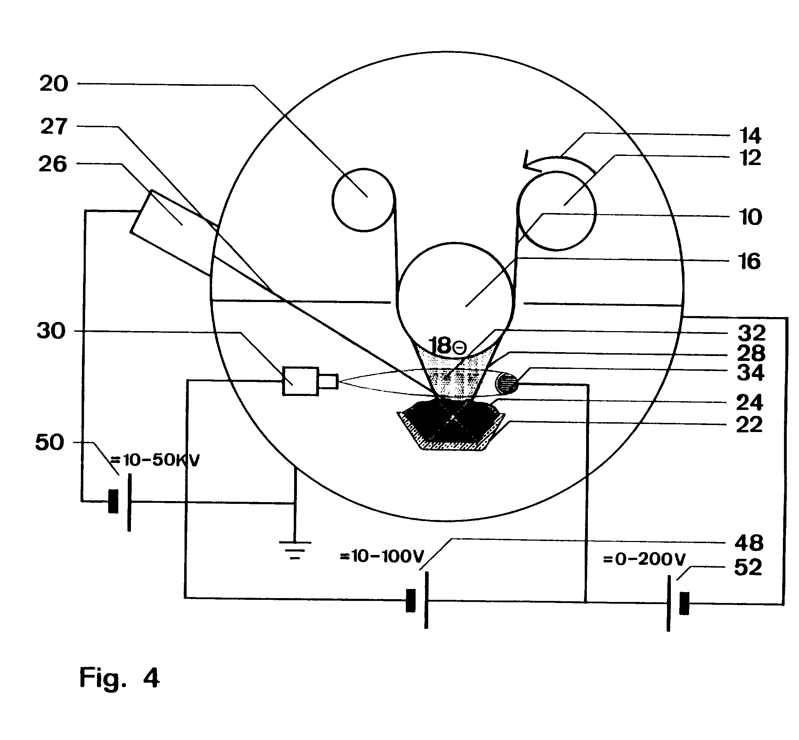

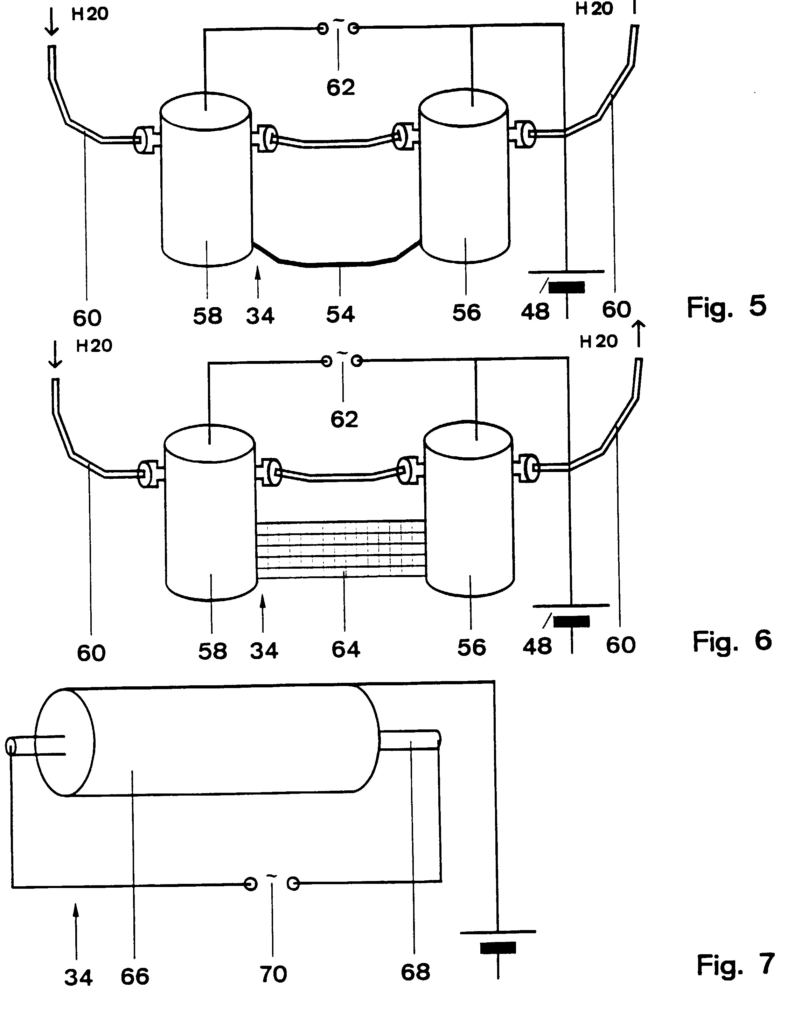

Die Beschreibung von Fig. 3 trifft im wesentlichen auch auf Fig. 4 zu. Die Anode 34 der Niederspannungs-Elektronenstrahlkanone 30 ist nicht die verlängerte Tiegelwand 47, sondern eine in den Fig. 5-7 im Detail dargestellte, spezielle Ausführungsform. Die erste Stromquelle 48 ist mit der Anode 34 verbunden, die zweite Stromquelle 50 über eine geerdete Leitung mit der Tiegelwand 46. Mit einer weiteren Stromquelle 52 wird eine Zusatzspannung von 0-200 V angelegt.

Eine in Fig. 5 dargestellte Anode 34 einer Niederspannungs-Elektronenstrahlkanone umfasst ein heisses Wolfram-Filament 54, das an Halterungen 56, 58 befestigt ist. Diese rohrförmig ausgebildeten Halterungen 56, 58 haben eine isolierte Oberfläche und werden durch über isolierte Leitungen 60 zugeführtes Wasser gekühlt. Wahlweise wird über eine Wechselstromquelle 62 eine zusätzlich zum Plasma wirkende Heizungsspannung angelegt. Der kathodische Leiter der Gleichstromquelle 48 führt zur Niederspannungs-Elektronenstrahlkanone.

Fig. 6 unterscheidet sich von Fig. 5 dadurch, dass die heisse Anodenoberfläche aus einem Gitter 64 gebildet wird.

In Fig. 7 ist die heisse Anodenoberfläche ein Tantalrohr 66 mit einem axialen Heizdraht 68, an welchen eine Wechselstromquelle 70 angelegt ist. Einfachheitshalber sind die wassergekühlten Halterungen nicht dargestellt.

### Beispiel 1

Eine 12 µm dicke, 300 mm breite PET-Substratfolie wird mit SiO₂ beschichtet. Das SiO₂ wird über eine scannende Hochvolt-Elektronenstrahlkanone aufgeheizt und verdampft, indem der Strahl so abgelenkt wird, dass das Material linienförmig quer zur Bandlaufrichtung erhitzt wird. Zusätzlich zu dieser Hochvolt-Elektronenstrahlkanone ist eine Niederspannungs-Elektronenstrahlkanone, eine Hohlkathode, angeordnet. Das Plasma der Bogenentladung tritt durch den SiO₂-Dampf hindurch und ionisiert den Dampf teilweise. Als Anode der Entladung dienen zehn aufgespannte Wolframdrähte, die sich durch das Plasma auf über 2000°C aufheizen und somit an ihrer Oberfläche leitfähig bleiben. Die Hohlkathode wird mit Argon betrieben. Im Tiegelbereich selber wird noch Stickstoff eingelassen, der auch teilweise inonisiert und zu sehr reaktivem atomaren Stickstoff aufgespalten wird. Als Resultat erhält man auf der PET-Substratfolie eine Siliziumoxinitritschicht, die sehr geringe Eigenspannungen aufweist und eine hervorragende Diffusiuonsbarriere für Gase, Aromastoffe, Wasserdampf und Ionen darstellt.Insbesondere erhält man durch Aufdampfen einer solchen Schicht auf eine Polymerfolie wie die oben angeführte Polyesterfolie eine hervorragende Barrierefolie, die sich durch Laminieren, Bedrucken oder Extrudieren zu hervorragenden Packstoffen weiterverarbeiten lässt. Der Plasmastrom der Hohlkathode beträgt ca. 200 A, die Spannung 50 V, die an der beheizten Anode zusätzlich angelegten Ziehspannung beträgt 150 V. Ueber diese an der nicht beschichteten Anode angelegte Ziehspannung werden zurückgestreute Elektronen der HV-Elektronenstrahlkanone abgeleitet und führen somit nicht mehr zu einer elektrostatischen Aufladung der PET-Folie. Die Bandgeschwindigkeit bei der Beschichtung beträgt 200 m/min, die Schichtdicke ca. 50 nm.

Zusätzlich kann noch mittels entsprechender hufeisenförmiger Polschuhe und mit Gleichstrom betriebenen Spulen ein Magnetfeld eingebracht werden, derart, dass dessen Hauptfeldkomponenten parallel zum Plasmastrahl verlaufen. Dieses Magnetfeld mit einer Stärke von mindestens 40 Gauss wirkt als Elektronenfalle, sowohl für die Plasmaelektronen als auch für die vom Tiegel zurückgestreuten schnellen Elektronen. Durch den Magnetfalleneffekt kann die Plasmadichte im Bereich des Dampfes noch einmal erheblich erhöht werden, was zu einer geringeren einzubringenden Hohlkathodenleistung führt.

### Beispiel 2

Eine 20 µm dicke und 1.50 m breite Substratfolie aus gerichtetem Polypropylen (oPP) wird mit Siliziummonoxid beschichtet. Ein Tiegel aus Graphit von 2 m Länge wird über Strahlungsheizer erwärmt. Zwischen dem Tiegel und der Substratfolie sind fünf Hohlkathoden angeordnet, so dass jede Kanone etwa auf 30 mm Materialbreite einwirkt. Die Hohlkathodenelektrode besteht aus LaB₆, weshalb die Hohlkathode direkt mit einem Stickstoff/Sauerstoff-Gemisch in einem Atomverhältnis 1:1 betrieben werden. Das dabei sehr stark ionisierte und chemisch aktivierte Gasgemisch reagiert sehr gut mit dem Siliziummonoxiddampf, wodurch sich wieder eine ähnliche Siliziumoxinitritschicht ausbildet wie im Beispiel 1. Auch in diesem Fall kommt eine Wolfram-Anode zum Einsatz, sie ist als Gitter ausgebildet.

### Beispiel 3

Eine Aluminiumfolie wird mit Aluminiumoxid beschichtet. Als Verdampfer dient eine Verdampferschiffchenbank, wie bei Standard-Aluminium-Metallisieranlagen. Die Verdampferschiffchen bestehen aus dotiertem Bornitrit. Mehrere Hohlkathoden sind über die Beschichtungsbreite angeordnet, äquidistant alle 40 cm. Die Hohlkathoden werden mit Argon-Gas betrieben. In der Nähe des Substrates lässt man noch zusätzlichen Sauerstoff ein, in einer solchen Menge, dass der gesamte Aluminiumdampf während der Kondensation auf der Aluminiumfolie zu Aluminiumoxid oxidiert wird. Durch die so abgeschiedene 40 nm dicke Schicht erhält man eine sehr viel korrosionsresistentere Aluminiumfolie. Auch in diesem Fall benötigt man eine heisse Anode für die Bogenentladung, sie besteht aus dotiertem Bornitrit.

## Patentansprüche

1. Verfahren zum Beschichten einer Substratfläche (18) mit einer Permeationssperre aus anorganischem Material (24), welches in einer auf wenigstens 10⁻³ mbar evakuierten Vakuumkammer (44) aus einem Tiegel (22) mit einem Elektronenstrahl (27) aus einer Hochspannungs-Elektronenstrahlkanone (26) verdampft und auf der Substratfläche (18) niedergeschlagen wird, wobei ein ionisierender Elektronenstrahl (32) niedriger Energie unter Bildung eines Plasmas durch die Gasphase (28) aus anorganischem Material (24) geleitet wird,
dadurch gekennzeichnet, dass
der ionisierende Elektronenstrahl (32) niedriger Energie in etwa parallel zur Substratfläche (18) verlaufender Richtung auf eine heisse, an ihrer Oberfläche leitfähig bleibende Anode (34) geleitet wird.

2. Verfahren nach Anspruch 1, dadurch gekennzeichnet, dass der Elektronenstrahl (32) niedriger Energie von wenigstens einer Niederspannungs-Elektronenstrahlkanone (30) mit einer Spannung von 10 - 100 V und einer Stromstärke von 0 - 300 A, vorzugsweise unter Zudosierung eines Edelgases oder von Stickstoff, betrieben wird.

3. Verfahren nach Anspruch 1 oder 2, dadurch gekennzeichnet, dass die Hochspannungs-Elektronenstrahlkanone (26) mit einer Spannung von gleich oder grösser als 5 kV und einer Stromstärke gleich oder kleiner als 2 A betrieben wird.

4. Verfahren nach einem der Ansprüche 1 bis 3, dadurch gekennzeichnet, dass an ein elektrisch leitendes Substrat eine Biasspannung mit negativem Potential zur Beschleunigung der ionischem Materialteilchen angelegt wird.

5. Verfahren nach einem der Ansprüche 1 bis 4, dadurch gekennzeichnet, dass ein zusätzliches Magnetfeld erzeugt wird, wobei dessen Hauptfeldkomponenten vorzugsweise parallel zum Plasmastrahl verlaufen.

6. Verfahren nach einem der Ansprüche 1 bis 5, dadurch gekennzeichnet, dass das Beschichten mit einer Niederschlagsrate von wenigstens 0,01 µm/sec, vorzugsweise 0,5-1µm/sec, erfolgt.

7. Verfahren nach einem der Ansprüche 1 bis 6, dadurch gekennzeichnet, dass eine mit einer Geschwindigkeit von 1 bis 10 m/sec, vorzugsweise 3 - 6 m/sec, durchlaufende Kunststoffolie (10) beschichtet wird.

8. Verfahren nach einem der Ansprüche 1 bis 7, dadurch gekennzeichnet, dass während des Beschichtens wenigstens ein reaktives Gas, vorzugsweise Sauerstoff, Stickstoff, Wasserstoff und/oder Acetylen, zugeführt wird.

9. Beschichtungswerkzeug zur Durchführung des Verfahrens nach einem der Ansprüche 1 bis 8, mit in einer Vakuumkammer (44) angeordneten Tiegel (22) und Substratträger (16) mit Substratfläche (18), sowie mit einer Hochspannungs-Elektronenstrahlkanone (26),
dadurch gekennzeichnet, dass
zwischen Tiegel (22) und Substratträger (16) wenigstens eine Niederspannungs-Elektronenstrahlkanone (30) mit zugeordneter Anode (34, 47) in die Vakuumkammer (44) eingebaut ist, wobei die Elektronenstrahlkanone (30) und die Anode (34, 47) gegenseitig so angeordnet sind, dass der zwischen ihnen erzeugte Elektronenstrahl (32) etwa parallel zur Substratfläche (18) verläuft.

10. Beschichtungswerkzeug nach Anspruch 9, dadurch gekennzeichnet, dass die Niederspannungs-Elektronenstrahlkanone/n (30) als Hohlkathoden-Elektronenquelle ausgebildet ist/sind, bei mehr als einem Elektronenstrahl (32) vorzugsweise mit überlappenden Wirkungsbereichen.

11. Beschichtungswerkzeug nach Anspruch 9 oder 10, dadurch gekennzeichnet, dass die Anode/n (34) der Niederspannungs-Elektronenstrahlkanone/n (30) als Wolfram-Filament (54), Wolfram-Gitter (64) oder Tantalrohr (66), bevorzugt mit wassergekühlten Halterungen (56, 58), ausgebildet sind.

12. Anwendung des Verfahrens nach einem der Ansprüche 1 bis 8 zur Beschichtung von Kunststoffolien (10) für die Verpackungsindustrie.

## Claims

1. Method of coating a substrate surface (18) with a permeation barrier of inorganic material (24) which is evaporated from a crucible (22) in a vacuum chamber (44) evacuated to at least 10⁻³ mbar by an electron beam (27) from a high-voltage electron gun (26) and deposited on the substrate surface (18), an ionising low-energy electron beam (32) being directed through the gas phase (28) of inorganic material (24) with the formation of a plasma, characterised in that the ionising low-energy electron beam (32) is directed on to a hot anode (34) remaining conductive on its surface in a direction substantially parallel to the substrate surface (18).

2. Method according to claim 1, characterised in that the low-energy electron beam (32) of at least one low-voltage electron gun (30) is operated with a voltage of 10 - 100 V and a current intensity of 0 - 300 A, preferably with the addition of an inert gas or nitrogen.

3. Method according to claim 1 or claim 2, characterised in that the high-voltage electron gun (26) is operated with a voltage greater than or equal to 5 kV and a current intensity less than or equal to 2 A.

4. Method according to one of claims 1 to 3, characterised in that a bias voltage with negative potential is applied to an electrically conductive substrate in order to accelerate the ionic material particles.

5. Method according to one of claims 1 to 4, characterised in that an additional magnetic field is generated, its main field components preferably extending parallel to the plasma jet.

6. Method according to one of claims 1 to 5, characterised in that coating is effected at a deposition rate of at least 0.01 µm/sec, preferably 0.5 - 1 µm/sec.

7. Method according to one of claims 1 to 6, characterised in that a plastic film (10) passing through at a rate of 1 to 10 m/sec, preferably 3 - 6 m/sec, is coated.

8. Method according to one of claims 1 to 7, characterised in that at least one reactive gas, preferably oxygen, nitrogen, hydrogen and/or acetylene is supplied during coating.

9. Coating implement for carrying out the method according to one of claims 1 to 8, comprising a crucible (22) arranged in a vacuum chamber (44) and a substrate support (16) with a substrate surface (18), as well as a high-voltage electron gun (26), characterised in that at least one low-voltage electron gun (30) with an associated anode (34, 47) is installed in the vacuum chamber (44) between the crucible (22) and the substrate support (16), the electron gun (30) and the anode (34, 47) being arranged in such a manner relative to one another that the electron beam (32) generated between them extends approximately parallel to the substrate surface (18).

10. Coating implement according to claim 9, characterised in that the low-voltage electron gun/s (30) is/are designed as a hollow-cathode electron source, preferably with overlapping effective regions if there is more than one electron beam (32).

11. Coating implement according to claim 9 or claim 10, characterised in that the anode/s (34) of the low-voltage electron gun/s (30) is/are designed as a tungsten filament (54), tungsten grating (64) or tantalum tube (66), preferably with water-cooled mountings (56, 58).

12. Application of the method according to one of claims 1 to 8 for coating plastic films (10) for the packaging industry.

## Revendications

1. Procédé de revêtement d'une surface de substrat (18) avec une barrière imperméable en matériau inorganique 2(24), qui est évaporé dans une chambre à vide (44) vidée à au moins 10⁻³ mbar à partir d'un creuset (23) avec un faisceau d'électrons (27) provenant d'un canon à faisceau d'électrons à haute tension, et est déposé sur la surface du substrat (18), un faisceau d'électrons ionisant (32) d'énergie plus faible avec formation d'un plasma étant dirigé à travers la phase gazeuse (28) du matériau inorganique (24),
caractérisé en ce que le faisceau d'électrons ionisant (32) de plus faible énergie est dirigé selon une direction approximativement parallèle à la surface du substrat (18) sur une anode (34) chauffée, demeurant conductrice superficiellement.

2. Procédé selon la revendication 1, caractérisé en ce que le faisceau d'électrons (32) de plus faible énergie d'au moins un canon à faisceau d'électrons à basse tension (30) est actionné à l'aide d'une tension de 10-100 V et une intensité de 0-300 A, de préférence avec dosage d'un gaz noble ou d'azote.

3. Procédé selon la revendication 1 ou 2, caractérisé en ce que le canon à faisceau d'électrons à haute tension (26) est commandé à l'aide d'une tension égale ou supérieure à 5 kV et une intensité de courant égale ou inférieure à 2 A.

4. Procédé selon l'une quelconque des revendications 1 à 3, caractérisé en ce qu'à un substrat électriquement conducteur est appliquée une tension de polarisation à potentiel négatif en vue de l'accélération des particules ionisées du matériau.

5. Procédé selon l'une quelconque des revendications 1 à 4, caractérisé en ce qu'un champ magnétique supplémenaire est créé, dont les composantes de champ principales s'étendent parallèlement au faisceau de plasma.

6. Procédé selon l'une quelconque des revendications 1 à 5, caractérisé en ce que le revêtement s'effectue à une vitesse de dépôt d'au moins 0,01 µm/sec, de préférence 0,5 à 1 µm/sec.

7. Procédé selon l'une quelconque des revendications 1 à 6, caractérisé en ce qu'une pellicule de matière plastique (10) se déplaçant à une vitesse de 1 à 10 m/sec, de préférence de 3 à 6 m/sec, est revêtue.

8. Procédé selon l'une quelconque des revendications 1 à 7, caractérisé en ce que durant le revêtement, un gaz réactif, de préférence de l'oxygène, de l'azote, de l'hydrogène et/ou de l'acétylène, est délivré.

9. Dispositif de revêtement en vue de la mise en oeuvre du procédé selon l'une quelconque des revendications 1 à 8, équipé d'un creuset (22) disposé dans une chambre à vide (44) et d'un support de substrat (16) avec une surface de substrat (18), ainsi que d'un canon à faisceau d'électrons à tension élevée (26), caractérisé en ce que
entre le creuset (22) et le support de substrat (16) est incorporé, dans la chambre à vide (44), au moins un canon à faisceau d'électrons à basse tension (30) avec anode associée (34, 47), le canon à faisceau d'électrons (30) et l'anode (34, 47) étant disposés mutuellement de sorte que le faisceau d'électrons (32) créé entre eux s'étend approximativement à la surface du substrat (18).

10. Dispositif de revêtement selon la revendication 9, caractérisé en ce que le ou les canons à faisceau d'électrons à basse tension (30) est/sont réalisés sous la forme de source d'électrons à cathodes creuses, dans le cas de plus d'un faisceau d'électrons (32) de préférence avec des zones d'action se chevauchant.

11. Dispositif de revêtement selon la revendication 9 ou 10, caractérisé en ce que l'anode ou les anodes (34) du ou des canons à faisceau d'électrons à basse tension (30) sont réalisées sous la forme d'un filament de tungstène (54), d'une grille de tungstène (64) ou d'un tube de tantale (66), de préférence avec des supports refroidis par eau (56, 58).

12. Application du procédé selon l'une quelconque des revendications 1 à 8 au revêtement de pellicules de matière plastique (10) pour l'industrie de l'emballage.
